# EUROPÄISCHE PATENTSCHRIFT

(11) **EP 1 872 995 B1**
(45) Veröffentlichungstag und Bekanntmachung des Hinweises auf die Patenterteilung: **28.04.2010**
(21) Anmeldenummer: 07012417.7
(22) Anmeldetag: 25.06.2007
(51) Int. Cl.: B60K 1/00

(54) **Antrieb für ein Kettenfahrzeug oder ein Fahrzeug mit Radseitenlenkung**
Drive for a tracked vehicle or a vehicle with wheel based steering
Dispositif d'entrâinement pour un véhicule à chenilles ou un véhicule à roues avec guidage par les roues latérales

(30) Priorität: 26.06.2006 DE 102006029571
(43) Veröffentlichungstag der Anmeldung: 02.01.2008
(73) Patentinhaber: Renk Aktiengesellschaft, 86159 Augsburg (DE)
(72) Erfinder: Döbereiner, Rolf, Dr., 86153 Augsburg (DE); Müller, Nikolaus, 80636 München (DE)
(74) Vertreter: Grünberger, Christian Thomas

(56) Entgegenhaltungen:
- WO-A-02/23115
- WO-A-97/08435
- DE-A1- 3 728 171
- DE-A1- 10 335 348
- DE-A1-102004 009 030
- DE-C1- 3 542 755
- JP-A- 55 011 346
- US-A- 3 817 321
- US-A1- 2004 118 142
- US-A1- 2005 072 176
- US-B1- 6 289 678
- WALDO E. RODLER ET AL: "Electrical Drive Study Volume 1 of 2; Contract Number DAAE07-84-C-RO17" Dezember 1987 (1987-12), US ARMY TANK-AUTOMOTIVE COMMAND RESEARCH, DEVELOPMENT & ENGINEERING CENTER , WARREN, MICHIGAN Gefunden im Internet: URL:http://stinet.dtic.mil/cgi-bin/GetTRDo c?AD=ADA395233&Location=U2&doc=GetTRDoc.pd f> [gefunden am 2008-08-22] * Absatz [5.3.4.1] * * Absatz [5.6.1.2] * * Seite 106, Zeilen 8-14, Absatz 5.6.3.12 * * Absatz [5.6.4.7] * * Absatz [5.12.6] * * Absatz [5.12.6.1] - Absatz [5.12.7] * * Abbildungen 5-86 * * Abbildungen 5-87 * * Abbildungen 5-88 *

## Beschreibung

Die Erfindung betrifft einen Antrieb für ein Kettenfahrzeug oder ein Fahrzeug mit Radseitenlenkung gemäß den Merkmalen des Patentanspruchs 1.

Aus der DE 37 28 171 C2 ist eine elektro-mechanische Antriebsanlage für ein Vollkettenfahrceug bekannt. Die Leistung eines Verbrennungsmotors wird durch einen Generator in elektrische Energie umgewandelt und über Elektromotoren wieder als mechanische Antriebsleistung verwendet. Hierzu ist ein elektrischer Fahrmotor vorgesehen, der eine Zentralwelle antreibt, welche jeweils über eine Differentialgetriebeanordnung mit den beiden Kettenantriebsrädern verbunden ist. Für die Lenkung des Kettenfahrzeugs ist ein elektrischer Lenkmotor vorgesehen, der über eine Nullwelle in gegensätzlicher Richtung in die Differentialgetriebeanordnungen eintreibt.

Aus DE 10 2004 009030 ist ein paralleler Hybridantrieb für Kettenfahrzeuge bekannt, bei dem der beispielsweise als Starter/Generator ausgeführte Elektromotor zusätzlich bei Bedarf für den Fahrantrieb genutzt werden kann. Oft ist bei solchen Anordnungen die Leistung des Elektromotors wesentlich kleiner als die des Verbrennungsmotors. Sie werden auch als "Mild Hybrid Layout" bezeichnet.

Es ist auch ein leistungsverzweigter Hybridantrieb für Kettenfahrzeuge bekannt. Dabei werden der Primärenergieerzeuger (Dieselmotor oder Gasturbine) und zwei Elektromotoren über ein Planetengetriebe derart verbunden, dass die Drehzahl des Primärenergieerzeugers von der Getriebeeintriebsdrehzahl entkoppelt ist, gleichwohl aber eine mechanische Verbindung bestehen bleibt, um einen hohen Wirkungsgrad zu ermöglichen. Die Integration von zwei Elektromotoren erlaubt es, jeweils einen Motor generatorisch und den anderen motorisch zu betreiben. Der Einbau von Traktionsbatterien - einem Energiespeicher, der speziell für die Bereitstellung von Antriebsenergie ausgelegt ist - im Fahrzeug kann damit entfallen. Während der Stillstandszeiten des Fahrzeugs kann der Primärenergieerzeuger abgeschaltet werden. Für einen Schnellstart kann elektrisch angefahren werden, wobei die elektrische Energie von einer im Fahrzeug ebenfalls installierten APU (Auxilliary Power Unit = Zusatzstromaggregat) bereitgestellt werden kann.

Die allgemein bekannten leistungselektronischen Bauteile (Leistungselektroniken) zur Bereitstellung elektrischer Energie, die heute in Powerpacks (Antriebsaggregat bestehend aus Motor und Getriebeeinheit) für Kettenfahrzeuge eingesetzt werden, sind auf einer mit Kühlwasser durchströmten Platte montiert, um die Abwärme abzuführen. Die Oberseite der Bauteile wird von Luft umströmt, die, um Hotspots zu vermeiden, über Ventilatoren zirkuliert. Aufgrund des mehrfachen Wärmeübergangs von Kühlwasser über mehrere Gehäusewände bis zum Entstehungsort der Abwärme im Bauteil, wird eine relative große Temperaturdifferenz zwischen Kühlwasser und Bauteil gefordert. Üblicherweise wird eine Kühlwasservorlauftemperatur von maximal 70°C gefordert.

Aus G 93 09 428 U1, der WO 97/08435 A und der US 2004/118142 A1 ist es bekannt, elektronische Bauteile bzw. einen Motor durch ein Siedekühlverfahren zu kühlen.

Aus Waldo E. Rodler Jr. et al., Technical Report No. 13 2 36 ("Electric Derive Study") US Army Tank-Automotrice Command RD& E Center, Warren (MI) ist ein Antrieb nach dem Oberbegriff des Anspruchs 1 bekannt.

Die Aufgabe der Erfindung ist es, die Kühlung der in Fahrzeugen, insbesondere in Kettenfahrzeugen oder Fahrzeugen mit Radseitenlenkung verwendeten Leistungselektronik zu verbessern.

Diese Aufgabe wird erfindungsgemäß durch die Merkmale des Patentanspruchs 1 gelöst.

Die Leistungs- und Steuerelektroniken für die elektrischen Motoren des (Hybrid-) Antriebs, die Getriebesteuerung, die Primärenergieerzeugersteuerung sowie die Steuerung für den Generator der APU kann vorteilhaft in den Powerpack bestehend aus Primärenergieerzeuger, Lastschalt- und Lenkgetriebe und Kühlanlage integriert werden.

Die leistungselektronischen Bauteile (Leistungselektronik) befinden sich erfindungsgemäß in einem separaten dicht abgeschlossenen Gehäuse, das vorteilhaft im Getriebegehäuse integriert werden kann. Die Leistungselektronik wird besonders vorteilhaft über eine Siedekühlung gekühlt, wie sie z.B. aus G 93 09 428.0 bekannt ist. Das Fluid, in dem die elektronischen Bauelemente ohne Gehäuse eingetaucht sind, weist eine Siedetemperatur auf, die unter der für diese Bauteile kritischen Betriebstemperatur liegt. Während des Siedevorgangs bleibt die Fluidtemperatur konstant. Der Dampf kondensiert an der Gehäusewand und steht somit verflüssigt wieder dem Siedeprozess zur Verfügung. Der Dampf kann alternativ zu einem Kondensator geleitet werden, der mit Umgebungsluft angeströmt und somit gekühlt wird. Die Umgebungsluft kann dem Luftmassenstrom der Kühlanlage entnommen werden und kann gleichzeitig dazu dienen, den Motorraum zu belüften.

Aufgrund der erfindungsgemäß vom Kühlwasser unabhängigen Kühlung der leistungselektronischen Bauteile (Leistungselektronik) entfällt die Begrenzung der Kühlwassertemperatur. Auch bei hohen Außentemperaturen (> 50°C) ist sichergestellt, dass die Elektroniken nicht überhitzen. Die erfindungsgemäß angeordnete Leistungselektronik kann deshalb vorteilhaft im Motorraum oder Getriebegehäuse integriert werden, wo Temperaturen von weit über 100°C herrschen können.

Die Gesarntantridbsleistung des Fahrzeugs kann je nach Anforderung an das Fahrzeug auf Primärenergieerzeuger und APU in einem entsprechenden Verhältnis aufgeteilt werden. Die APU dann kann vorteilhaft im Powerpack integriert werden, weil der Primärenergieerzeuger des Hybridantriebes entsprechend kleiner ausgeführt ist. Für kurzzeitigen Spitzenleistungsbedarf kann elektrische Leistung der APU über die Hybrideinheit dem Antrieb zusätzlich zugeführt werden (Boosten). Während die APU permanent läuft, kann der Primärenergieerzeuger bei längeren Stillstandzeiten vorteilhaft abgeschaltet werden.

Die Erfindung wird anhand eines Ausführungsbeispiels nachfolgend näher erläutert. Dabei zeigt:
- Fig. 1: eine schematische Anordnung der Antriebselemente eines erfindungsgemäßen Fahrzeugs und
- Fig. 2: stellt die schematische Anordnung der Antriebselemente im Motorraum eines erfindungsgemäßen Fahrzeuges dar.

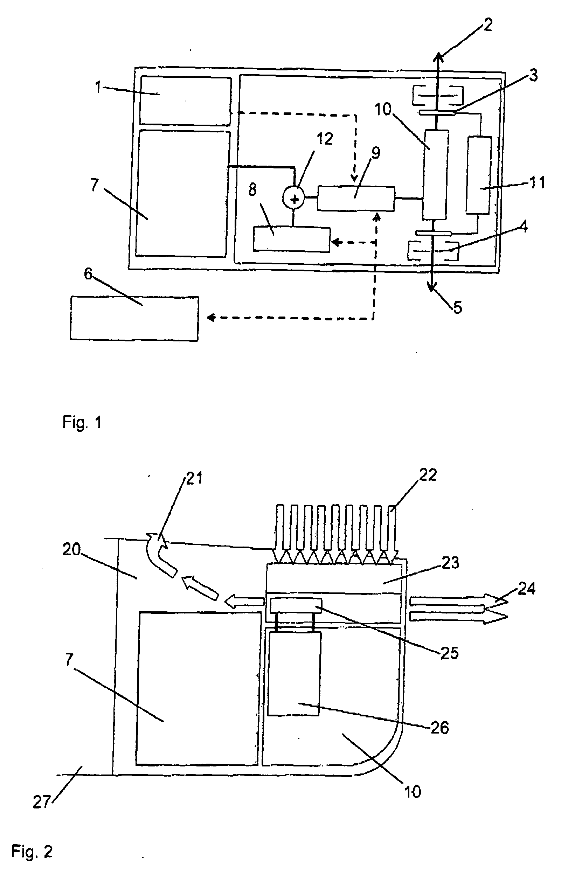

Die in Fig. 1 schematisch dargestellte Antriebseinheit eines beispielhaften Fahrzeugs verfügt über einen Hybridantrieb, bestehend aus einem Primärenergieerzeuger (7), vorzugsweise ein Dieselmotor oder eine Gasturbine, der über eine Hybrideinheit (12) mit zwei Elektromaschinen (8, 9) gekoppelt ist. Die Elektromaschinen (8, 9) können sowohl als Generator als auch als Elektromotor betrieben werden.

Die eine Elektromaschine (9) ist direkt mit einem beispielhaften Lastschaltgetriebe (10) verbunden, an dessen Abtrieben (2, 5) jeweils ein Differentialgetriebe (3) und eine Bremse (4) angeordnet sind. Mit einem Lenkmotor (11) kann über die Differentialgetriebe (3) Antriebsleistungen von einem zum anderen Abtrieb (2, 5) übertragen werden. Dadurch ergeben sich an den Abtrieben unterschiedliche Drehzahlen, die dazu führen, dass das Fahrzeug eine Kurve fährt. Falls die Abtriebe (2, 5) mit Kettenrädern verbunden sind, werden die unterschiedlichen Fahrgeschwindigkeiten über Gleitketten auf die Fahrbahn übertragen. Es ist jedoch auch möglich, die Räder eines Fahrzeugs anzutreiben, das durch eine Radseitenlenkung gelenkt wird. Nähere Einzelheiten zum Hybridantrieb sowie zur Lenkung von Kettenfahrzeugen bzw. Fahrzeugen mit Radseitenlenkung sind aus der nicht vorher öffentlichten DE 10 2005 035 824.1 zu entnehmen.

Aus Fig. 1 ist weiterhin ein Zusatzstromaggregat (1) ersichtlich, das über einen weiteren Primärenergieerzeuger sowie einen Generator Strom erzeugt. Das Zusatzstromaggregat (1) kann auch als Auxilliary Power Unit APU bezeichnet werden. Der vom APU erzeugte Strom kann auch für den Fahrantrieb verwendet werden und wird hierzu den Elektromotoren (8, 9) zugeführt.

Weiterhin kann ein Batteriespeicher (6) vorgesehen werden, der von den Elektromaschinen (8, 9) im Generatorbetrieb geladen werden kann. Bei Bedarf kann die elektrische Energie aus dem Batteriespeicher (6) wieder zu den Elektromaschinen (8, 9) zurückgeführt werden, wenn diese als Fahrmotor wirken.

Zur Umformung, Steuerung und Schaltung der elektrischen Ströme und Spannungen sind elektronische Bauelemente notwendig, die als leistungselektronische Bauelemente oder als Leistungselektronik bezeichnet werden.

Die für das beispielhaft beschriebene Fahrzeug vorgesehene Leistungselektronik geht aus Fig. 2 hervor. In Fig. 2 ist eine schematische Seitenansicht des Motorraums (20) des Fahrzeugs (27) dargestellt. Der Primärenergieerzeuger (7) und das Getriebe (10) sind kompakt direkt nebeneinander angeordnet. Über dem Getriebe (10) ist eine Kühlanlage (23) vorgesehen, welche zur Kühlung des Getriebes (10) sowie der Primärenergieerzeuger (7) vorgesehen ist. Über nicht dargestellte Lüfterräder wird Luft (22) aus der Umgebung des Fahrzeugs (27) angesaugt und durch die Kühlanlage (23) geführt. Ein Teil dieser Luft wird auch zur Belüftung des Motorraums (20) genutzt. Die erwärmte Luft wird zum Teil als Abluft (21) aus dem Motorraum und als Abluft (24) aus der Kühlanlage abgeführt.

Die Leistungselektronik ist im Getriebe (10), vorzugsweise nahe an den Elektromotoren (8, 9) angeordnet, welche ebenfalls vorzugsweise im Getriebegehäuse (10) untergebracht sind. Aufgrund der Nähe zu den Elektromotoren (8, 9) muss die hohe elektrische Antriebsleistung nur über eine kurze Strecke in einem elektrischen Hochspannungszwischenkreis geführt werden.

Die leistungselektronischen Bauteile (26) werden vorzugsweise in einem separaten, dicht geschlossenen Gehäuse angeordnet und über ein Fluid im Siedekühlverfahren gekühlt. Dabei tauchen die leistungselektronischen Bauelemente (26) direkt in das vorzugsweise hochisolierende Fluid ein und erhitzen dieses bis zum Sieden. Während des Siedevorganges behält das Fluid seine Siedetemperatur konstant bei und ein Teil des Fluids verdampft. Der Dampf kann an der Gehäusewand kondensieren und steht somit wieder verflüssigt für die Kühlung bereit.

Vorzugsweise wird das Fluid so gewählt, dass es besser isoliert als Luft und die elektronischen Bauteile können deshalb enger zueinander angeordnet werden. Eine siedegekühlte Leistungselektronik benötigt deshalb weniger Bauraum und kann beispielsweise vorteilhaft in das Getriebegehäuse eines Fahrzeugs, insbesondere eines Kettenfahrzeugs oder eines Fahrzeugs mit Radseitenlenkung, integriert werden.

Zur Rückkühlung und/oder zur Kondensation des Dampfes kann ein Fluid / Luft-Wärmetauscher oder ein Kondensator vorgesehen werden. Der Fluid / Luft-Wärmetauscher / Kondensator ist über eine oder mehrere Verbindungsleitungen mit dem Gehäuse der Leistungselektronik verbunden und wird vorzugsweise von Umgebungsluft angeströmt und gekühlt, die vorzugsweise dem Luftmassenstrom der Kühlanlage entnommen wird. Diese Luft kann gleichzeitig zur Belüftung des Motorraums verwendet werden.

Durch entsprechende Maßnahmen kann erreicht werden, dass sich der Druck im Kondensator bzw. Fluid / Luft-Wärmetauscher gegenüber dem Druck im Gehäuse der Leistungselektronik unterscheidet. Da die Siedetemperatur druckabhängig ist, können für den Kondensator und das Gehäuse der Leistungselektronik jeweils entsprechend günstige Temperaturniveaus gewählt werden.

Nähere Einzelheiten zum Siedekühlverfahren können beispielsweise DE-G 93 09 428 U1 entnommen werden.

Aufgrund der vom Kühlwasser des Fahrzeugkühlsystems (23) unabhängigen Kühlung der Leistungselektronik entfällt eine Begrenzung der Kühlwassertemperatur. Wenn beispielsweise die elektronischen Bauteile maximal 100°C bis 120°C ertragen können, müsste die Kühlwassertemperatur wegen des mehrfachen Wärmeübergangs auf 70°C bis 80°C begrenzt werden. Da die Begrenzung bei Siedekühlung entfällt, kann das Fahrzeugkühlsystem (23) bei einer höheren Temperatur betrieben werden und weist daher eine vorteilhaft höhere Kühlleistung für die Motoren, Getriebe, etc. auf, da sich die Temperaturdifferenz ΔT zwischen Kühlluft und Wasservorlauftemperatur vergrößert. Durch die Siedekühlung ist auch bei hohen Umgebungstemperaturen sichergestellt, dass die Leistungselektronik nicht überhitzt. Deshalb ist es vorteilhaft möglich, die Leistungselektronik z.B. innerhalb des Motorraums / Powerpacks oder innerhalb eines Getriebegehäuses eines Fahrzeuges zu integrieren. Besonders vorteilhaft ist dies bei Kettenfahrzeugen bzw. Fahrzeugen mit Radseitenlenkung, wo im Motorraum / Powerpack oder im Getriebegehäuse Spitzentemperaturen von weit über 100°C herrschen können.

Bei einer beispielhaften Temperaturbegrenzung von leistungselektronischen Bauteilen auf 80°C ist ein Kühlfluid mit einem entsprechenden Siedepunkt auszuwählen.

Bei Fahrzeugen, die neben einer Hauptantriebsanlage zusätzlich ein Zusatzstromaggregat zur Stromversorgung von elektrischen Verbrauchern benötigen, ist es im Fall eines Hybridhauptantriebes vorteilhaft möglich, die erforderliche Gesamtantriebsleistung durch den Primärenergieerzeuger des Hybridantriebes und das Zusatzstromaggregat gemeinsam aufzubringen. In diesem Fall könnte der Primärenergieerzeuger so viel kleiner ausgelegt werden, dass das entsprechend größer zu dimensionierende Zusatzstromaggregat im verbleibenden Bauraum des Motorraums / Powerpacks des Fahrzeuges untergebracht werden kann. Somit wird der bisherige Unterbringungsort des Zusatzstromaggregats für andere (Nutz-) Zwecke frei.

Die maximale Fahrantriebsleistung zum Beschleunigen eines derartigen Fahrzeugs kann bereitgestellt werden, indem der Primärenergieerzeuger des Hybridantriebs (Dieselmotor, Gasturbine oder sonstige Wärmekraftmaschine) das Fahrzeug direkt antreibt und der elektrische Fahrantrieb (ein oder mehrere Elektromotoren) - durch das Zusatzstromaggregat mit elektrischer Energie versorgt - ebenfalls zur Beschleunigung des Fahrzeuges beiträgt.

Vorzugsweise wird die Gesamtantriebsleistung zwischen dem Primärenergieerzeuger des Hybridantriebs und dem Zusatzstromaggregat so aufgeteilt, dass die elektrische Energie bzw. Leistung des Zusatzstromaggregats ausreicht, um das Fahrzeug in einer vorgegebenen Zeit auf eine vorgegebene Geschwindigkeit zu beschleunigen sowie gleichzeitig den Primärenergieerzeuger des Hybridantriebes zu starten.

Besonders vorteilhaft ist eine Aufteilung der Gesamtantriebsleistung, bei welcher der Primärenergieerzeuger des Hybridantriebs zwei Drittel der Leistung und das Zusatzstromaggregat ein Drittel der Leistung aufbringen.

Ausgehend von einem beispielhaften konventionellen Fahrzeug mit einem Primärenergieerzeuger mit 500 kW Leistung (V8 Dieselmotor) und einer APU mit 40 kW Leistung (V2 Dieselmotor) könnte ein entsprechendes Hybridfahrzeug mit einem Primärenergieerzeuger von 375 kW Leistung (V6 Dieselmotor) und einer APU von 125 kW Leistung (z.B. V4 Dieselmotor) ausgestattet sein.

Besonders vorteilhaft ist die Integration des Zusatzstromaggregats in den Motorraum (Powerpack) eines Kettenfahrzeugs oder Fahrzeugs mit Radseitenlenkung.

Die Integration einer siedegekühlten Leistungselektronik (26) in das Getriebegehäuse (10) ermöglicht eine besonders vorteilhafte Antriebsanordnung. Neben einem Primärenergieerzeuger, Elektromaschine (generatorisch oder motorisch betreibbar), Zusatzstromaggregat sowie Lastschalt-/Lenkgetriebe mit Getriebesteuerung wäre auch die Leistungselektronik im Motorraum untergebracht. Diese Baugruppen bilden dann zusammen eine integrative kompakte Antriebseinheit / Powerpack. Falls auf ein Getriebe verzichtet werden könnte, könnte die Leistungselektronik unabhängig vom Getriebegehäuse an anderer Stelle im Motorraum angeordnet werden.

### Bezugszeichenliste

- 1: Zusatzstromaggregat, Auxilliary Power Unit
- 2: Abtrieb
- 3: Lenkdifferential
- 4: Bremse
- 5: Abtrieb
- 6: Batteriespeicher
- 7: Primärenergieerzeuger: Dieselmotor oder Gasturbine
- 8: Elektromaschine: Elektromotor /Generator
- 9: Elektromaschine: Elektromotor / Generator
- 10: Lastschaftgetriebe
- 11: Lenkmotor
- 12: Hybrideinheit
- 20: Motorraum
- 21: Abluft, Motorraum
- 22: Umgebungsluft
- 23: Kühlanlage
- 24: Abluft der Kühlanlage
- 25: Fluid / Luft-Wärmetauscher / Kondensator
- 26: Leistungselektronik
- 27: Fahrzeug

## Patentansprüche

1. Antrieb für ein Kettenfahrzeug oder ein Fahrzeug mit Radseitenlenkung, mit mindestens einem Bauelement (8, 9), das elektrische Energie verbraucht und mindestens einem leistungselektronischen Bauelement (26) zur entsprechenden Bereitstellung der elektrischen Energie, **dadurch gekennzeichnet, dass** das leistungselektronische Bauelement (26) über ein Fluid im Siedekühlverfahren kühlbar und in einem Getriebegehäuse (10) angeordnet ist.

2. Antrieb nach Anspruch 1, **dadurch gekennzeichnet, dass** das leistungselektronische Bauelement (26) im Motorraum (20) des Fahrzeugs (27) angeordnet ist.

3. Antrieb nach einem der vorangehenden Ansprüche, **dadurch gekennzeichnet, dass** das leistungselektronische Bauelement (26) in einem separaten, dicht geschlossenen Gehäuse angeordnet ist und direkt in das Kühl-Fluid eintaucht.

4. Antrieb nach einem der vorangehenden Ansprüche, **dadurch gekennzeichnet, dass** zur Rückkühlung und Kondensation von bei der Kühlung entstehendem Dampf ein Fluid / Luft-Wärmetauscher oder Kondensator (25) vorgesehen ist.

5. Antrieb nach Anspruch 4, **dadurch gekennzeichnet, dass** der Fluid / Luft. Wärmetauscher oder Kondensator (25) durch Umgebungsluft des Fahrzeugs kühlbar ist.

6. Antrieb nach Anspruch 4 oder 5, **dadurch gekennzeichnet, dass** das Gehäuse des Leistungselektronischen Bauteils (26) und der Fluid / Luft-Wärmetauscher oder Kondensator (25) zum Austausch von Flüssigkeit oder Dampf miteinander verbunden sind und entsprechende Maßnahmen getroffen sind, so dass die Drücke im Fluid /Luft-Wärmetauscher oder Kondensator (25) und im Gehäuse der Leistungselektronik (26) ein unterschiedliches Niveau aufweisen.

7. Antrieb nach einem der vorangehendem Ansprüche, mit einem Primärenergieerzeuger (7), der mit einer elektrischen Maschine zusammenwirkt, die als Generator oder Fahrmotor betreibbar ist, sowie entsprechender Leistungs- und Steuerunngselektronik und einem Zusatzstromaggregat (1), **dadurch gekennzeichnet, dass** das Zusatzstromaggregat (1) im Motorraum/Powerpack (20) des Fahrzeugs angeordnet ist.

8. Antrieb nach Anspruch 7, **dadurch gekennzeichnet, dass** zusätzlich ein Lastschalt- und Lenkgetriebe (10) sowie eine Getriebesteuerungseinrichtung vorgesehen sind.

9. Kettenfahrzeug oder ein Fahrzeug mit Radseitenlenkung mit einem Antrieb nach einem der vorhergehenden Ansprüche.

## Claims

1. A drive for a tracked vehicle or a vehicle with wheel-based steering, having at least one component (8, 9) that consumes electric energy, and at least one power electronic component (26) for corresponding provision of the electric energy, **characterised in that** the power electronic component (26) can be cooled by way of a fluid in the boiling-cooling process and is arranged in a gear-unit housing (10).

2. A drive according to claim 1, **characterised in that** the power electronic component (26) is arranged in the engine compartment (20) of the vehicle (27).

3. A drive according to one of the preceding claims, **characterised in that** the power electronic component (26) is arranged in a separate, tightly closed housing and dips directly into the cooling fluid.

4. A drive according to one of the preceding claims, **characterised in that** a fluid/air heat exchanger or condenser (25) is provided in order to re-cool and condense vapour that develops during the cooling.

5. A drive according to claim 4, **characterised in that** the fluid/air heat-exchanger or condenser (25) can be cooled by ambient air of the vehicle.

6. A drive according to claim 4 or 5, **characterised in that** the housing of the power electronic component (26) and the fluid/air heat exchanger or condenser (25) are connected together in order to exchange liquid or vapour, and corresponding measures are taken so that the pressures in the fluid/air heat exchanger or condenser (25) and in the housing of the power electronics (26) have different levels.

7. A drive according to one of the preceding claims, having a primary energy producer (7), which cooperates with an electric machine that can be operated as a generator or traction motor, and also corresponding power and control electronics and a booster-current unit (1), **characterised in that** the booster-current unit (1) is arranged in the engine compartment/power pack (20) of the vehicle.

8. A drive according to claim 7, **characterised in that** a power-shifting and steering gear unit (10) and also a gear-unit control device are additionally provided.

9. A tracked vehicle or a vehicle with wheel-based steering having a drive according to one of the preceding claims.

## Revendications

1. Dispositif d'entraînement de véhicule à chenilles ou de véhicule à guidage par roues latérales comportant au moins un composant (8, 9) consommant de l'énergie et au moins un élément électronique de puissance (26) pour fournir de manière correspondante l'énergie électrique,
**caractérisé en ce que**
le composant électronique de puissance (26) est refroidi par un fluide par un procédé de refroidissement par ébullition, et il est installé dans un boîtier de transmission (10).

2. Dispositif d'entraînement selon la revendication 1,
**caractérisé en ce que**
le composant électronique de puissance (26) est installé dans l'enceinte du moteur (20) du véhicule (27).

3. Dispositif d'entraînement selon l'une des revendications précédentes,
**caractérisé en ce que**
le composant électronique de puissance (26) est placé dans un boîtier séparé, fermé de manière étanche, et il plonge directement dans le fluide de refroidissement.

4. Dispositif d'entraînement selon l'une des revendications précédentes,
**caractérisé par**
un échangeur de chaleur fluide/air ou condenseur (25) pour refroidir et condenser la vapeur provenant du refroidissement.

5. Dispositif d'entraînement selon la revendication 4,
**caractérisé en ce que**
l'échangeur de chaleur fluide/air ou condenseur (25) est refroidi par l'air ambiant du véhicule.

6. Dispositif d'entraînement selon la revendication 4 ou 5,
**caractérisé en ce que**
le boîtier du composant électronique de puissance (26) et l'échangeur de chaleur fluide/air ou condensateur (25), sont reliés pour échanger du fluide ou de la vapeur et des mesures sont prises pour que les pressions dans l'échangeur de chaleur fluide/air ou condenseur (25) et dans le boîtier de l'électronique de puissance (26), soient à des niveaux différents.

7. Dispositif d'entraînement selon l'une des revendications précédentes, comportant un générateur d'énergie primaire (7) coopérant avec une machine électrique fonctionnant comme générateur ou comme moteur de circulation ainsi qu'une électronique de commande ou de puissance correspondante et une unité d'alimentation électrique complémentaire (1),
**caractérisé en ce que**
l'unité d'alimentation électrique complémentaire (1) se trouve dans l'ensemble enceinte de moteur/groupe d'alimentation (20) du véhicule.

8. Dispositif d'entraînement selon la revendication 7,
**caractérisé par**
une transmission de commutation en charge et de direction (10) ainsi une installation de commande de transmission.

9. Véhicule à chenilles ou véhicule à guidage par roues latérales, comportant un moyen d'entraînement selon l'une des revendications précédentes.
